# EUROPEAN PATENT APPLICATION

(11) **EP 4 753 438 A1**
(43) Date of publication of application: **03.06.2026**
(21) Application number: 25219473.3
(22) Date of filing: 28.11.2025
(51) Int. Cl.: H10W 70/40, H10W 74/10

(54) **A SEMICONDUCTOR DEVICE AND A METHOD OF MANUFACTURING THE SEMICONDUCTOR DEVICE**

(30) Priority: 29.11.2024 NL 2039199
(71) Applicant: Nexperia B.V., 6534 AB Nijmegen (NL)
(72) Inventor: Liu, Xu, 6534 AB Nijmegen (NL); Liu, Haiyan, Shanghai (CN); Yuan, Zhihui, Munich (DE); Minotti, Agatino, Catania (IT)
(74) Representative: Pjanovic, Ilija

(57) **Abstract**

A method for manufacturing a semiconductor device is proposed, the method comprising: a) providing a lead frame structure with a first lead frame surface and an opposite second lead frame surface, where the lead frame structure comprises an outer frame, an at least one lead frame die pad, an at least one lead frame terminal, and the plurality of lead frame junctions. The at least one lead frame die pad and/or the at least one lead frame terminal are accommodated in a floating orientation within the lead frame structure; b) providing a pre-binding material for fixing the floating lead frame die pads and/or floating lead frame terminals within the lead frame structure; c) mounting an at least one semiconductor die on the at least one lead frame die pad; d) mounting an at least one connecting element for creating an electrical connection between the at least one semiconductor die and the at least one lead frame terminal, e) encapsulating by a mold compound the lead frame structure, the at least one semiconductor die, the at least one connecting element and the pre-binding material to form the semiconductor device, such that at least part of the at least one lead terminal is exposed and thereby forming an encapsulated semiconductor device. According to the second aspect of the disclosure, there is provided a semiconductor device as manufactured in accordance with the method according to the disclosure.

## Description

### TECHNICAL FIELD

The present disclosure relates to a semiconductor device and a method of manufacturing the semiconductor device. In particular, this disclosure relates to a semiconductor power packaging comprising the semiconductor device.

### BACKGROUND OF THE DISCLOSURE

The semiconductor power packages are manufactured as layered assemblies comprising semiconductor devices with semiconductor dies, die pads, connecting elements and a mold compound. Typical semiconductor devices comprise a semiconductor dies attached to a lead frame, connected connecting elements for electrical connections and are further encapsulated to form a packaged semiconductor device.

The semiconductor power packaging ensures high conversion efficiency and is widely used in applications requiring high efficiency, such as in vehicles and industrial systems. Traditionally, the semiconductor power package comprises semiconductor dies mounted on a ceramic substrate. One side of the ceramic substrate is suitable for semiconductor dies attachment and second side of the ceramic substrate is suitable for connecting with a heat sink. Commonly, heat sinks are baseplates or coolers. The heat generated by semiconductor dies is transferred through the ceramic substrate and the heat sink to a cooling liquid.

Common ceramic substrate has a layered structure and comprises a middle layer being a ceramic layer, a top layer being a copper circuited layer on which semiconductor dies are mounted and a bottom layer which is a copper layer connected to the heat sink. The ceramic layer comprises compounds such as Al₂O₃ (aluminium oxide), Si₃N₄ (silicon nitride) and AIN (aluminium nitride). In the state of the art, ceramic layers are commonly used as an insulation for the semiconductor power packaging and support for semiconductor dies. Typically, there are used connections components of DBC (Direct Bonded Copper) and AMB (Active Metal Brazed) ceramic substrates for power modules where copper layers are bonded to each surface of the ceramic layer. AMB substrate comprises the top layer being a copper layer, the ceramic layer, two layers of brazing alloy and the bottom layer which is the copper layer. Ceramic substrates feature high thermal conductivity, excellent copper electrical conductivity and superior insulation properties. Copper's high electrical conductivity enables the support of high current flow. The dielectric properties of ceramic substrates provide the high isolation required for densely packed circuits in power modules, the semiconductor power packaging. Effective insulation requirement is significant for the semiconductor power packaging.

The above-mentioned method uses the ceramic substrate for isolation purposes, but it encounters certain disadvantages with coefficient for thermal expansion (CTE) and subsequent delamination problems. The ceramic layer introduces several challenges to the packaging structure, including the low thermal conductivity of standard ceramics. A problem arises with the large CTE mismatch between the ceramic and the copper, and a longer thermal dissipation path caused by multiple layers of different materials within DBC and AMB substrates. The use of the ceramic substrate is associated with significant costs.

One solution is removing the ceramic layer from the ceramic substate leaving copper layers and to mount semiconductor dies directly on the lead frame being the top copper layer. Upon removal of the ceramic layer, the bottom copper layer is also removed, leaving only the top copper layer. In a typical switch case, adjusted lead frame die pads, external connecting elements and terminals are connected by small junctions. After the encapsulation process, only the junctions not covered by the encapsulation are trimmed. Such solution provides lower cost of a product, CTE matching and higher thermal performance. However, in more complex configuration such as a half-bridge, the problem with separated semiconductor pads and terminals occurs. In typical solution, these separated elements are supported and aligned in positions by the ceramic layer. After the ceramic layer is removed, these elements become free-standing and lack support during the assembly process.

Document US11476179B2 discloses a transistor package comprising: a substrate; a first transistor in thermal contact with the substrate, wherein the transistor comprises a gate; the substrate sintered to a heat sink through a sintered layer; an encapsulant that at least partially encapsulates the first transistor; and a Kelvin connection to the transistor gate. It comprises a ceramic insulation layer.

Fairchild's SPM55 series is a power module developed to provide a minimized package and low power consumption with improved reliability. There is applied a new 600 V gate-driving high-voltage integrated circuit (HVIC), a new insulated-gate bipolar transistor (IGBT) of advanced silicon technology. It discloses copper traces connected to a main lead frame and it comprises an insulation layer.

There is a need to address the disadvantages associated with semiconductor device and associated methods of manufacturing

Accordingly, it is a goal of the present disclosure to provide an improved method for manufacturing a semiconductor device without the insulation layer as a support layer for semiconductor dies enhancing thermal and electrical performance as well as such semiconductor device.

### SUMMARY OF THE DISCLOSURE

According to a first example of the disclosure, the object of the present disclosure has been achieved by providing a method for manufacturing a semiconductor device, the method comprising:
a) providing a lead frame structure with a first lead frame surface and an opposite second lead frame surface, where the lead frame structure comprises:
   an outer frame,
   an at least one lead frame die pad,
   an at least one lead frame terminal, and
   the plurality of lead frame junctions for local interconnections within the lead frame structure,
   wherein the at least one lead frame die pad and/or the at least one lead frame terminal are accommodated in a floating orientation within the lead frame structure;
b) providing a pre-binding material for fixing the floating lead frame die pads and/or floating lead frame terminals within the lead frame structure,
c) mounting an at least one semiconductor die on the at least one lead frame die pad;
d) mounting an at least one connecting element for creating an electrical connection between the at least one semiconductor die and the at least one lead frame terminal;
e) encapsulating by a mold compound the lead frame structure, the at least one semiconductor die, the at least one connecting element and the pre-binding material to form the semiconductor device, such that at least part of the at least one lead terminal is exposed and thereby forming an encapsulated semiconductor device.

Providing the pre-binding material ensures effective stability of the parts within the lead frame structure throughout the entire manufacturing process. The method eliminates the need for the ceramic layer, which introduces certain disadvantages to the semiconductor device. This feature further ensures a simplified and integrated process, characterized by lower costs.

Preferably, the pre-binding material is an epoxy mold compound EMC, glue or resin. Such materials can be easily dissolved at the end of the manufacturing method.

In a further example, the pre-binding material is a permanent pre-binding material when the pre-binding material is compatible with the mold compound applied during step e) or a temporary pre-binding material which is suitable for dissolving in a solution.

Preferably, in step b) the pre-binding material is provided between the at least one lead frame die pad, the at least one lead frame terminal and the lead frame junctions. Such an arrangement ensures a stable positioning of all parts within the lead frame structure and their equal alignment relative to each other.

Preferably, the pre-binding material has a thickness equal or thinner of a thickness of the lead frame structure. Varying thicknesses offer the advantage of reducing material consumption and creating space for the flow of the mold compound.

In a further example, step e) is followed by a step e1) of dissolving the pre-binding material.

Alternatively, the pre-binding material is a temporary holding material which is a HT tape or a tray plate with vacuum channels, preferably vacuum channels adjusted to the lead frame structure. Such materials can be easily removed at the end of the manufacturing method.

Preferably, in step b) the pre-binding material is attached to the second lead frame surface. Such fastening ensures uniform positioning of parts relative to each other.

In a further example, the at least one lead frame die pad and/or the at least one lead frame terminal are supported by an at least one clip. The clip features enhance the fixing force between parts of the lead frame structure.

Preferably, further after step e) is a step e2) removing the pre-binding material.

Preferably, step e) is followed by a step e3) trimming, using a trimming tool, residual material from the exposed parts of the lead frame structure.

In a further example, step e) is followed by a step e4) milling, using a milling device, locally through the encapsulating mold compound and through the plurality of lead frame junctions, thereby interrupting the local interconnection between the at least one lead frame die pad and the plurality of lead frame terminals.

Preferably, step e) is followed by a step e5) of mounting a heat sink component to the second lead frame surface. Such connections provide the transfer of generated heat from the lead frame structure to the heat sink.

According to the second aspect of the disclosure, there is provided a semiconductor device as manufactured in accordance with the method according to the disclosure.

### BRIEF DESCRIPTION OF THE DRAWINGS

The disclosure will now be discussed with reference to the drawings, which show in:
Figures 1 shows a lead frame in top view from a first lead frame surface and in cross section with a provided pre-binding material applied between elements of the lead frame structure;
Figure 2 shows a first example of the semiconductor device in top view from the first lead frame surface and in cross section with a provided pre-binding material applied between elements of the lead frame structure and mounted semiconductor dies and connecting elements;
Figures 3 shows the first example of the semiconductor device in top view from the first lead frame surface and in cross section with a mold compound;
Figure 4 shows three examples of the pre-binding material positioning;
Figure 5 shows a second example of the semiconductor device in top view from the first lead frame surface and in cross section with a provided pre-binding material in a form of a tray plate with vacuum channels and supported with clips;
Figures 6 shows the second example of the semiconductor device in top view from the first lead frame surface and in cross section with the mold compound;
Figure 7 shows the second example of the semiconductor device in top view from the first lead frame surface and in cross section with the mold compound and detaching the pre-binding material in the form of the tray plate with vacuum channels.

### DETAILED DESCRIPTION OF THE DISCLOSURE

For a proper understanding of the disclosure, in the detailed description below corresponding elements or parts of the disclosure will be denoted with identical reference numerals in the drawings.

To ensure a clear understanding of the disclosure, the detailed description below will use identical reference numerals in the drawings to denote corresponding elements or parts.

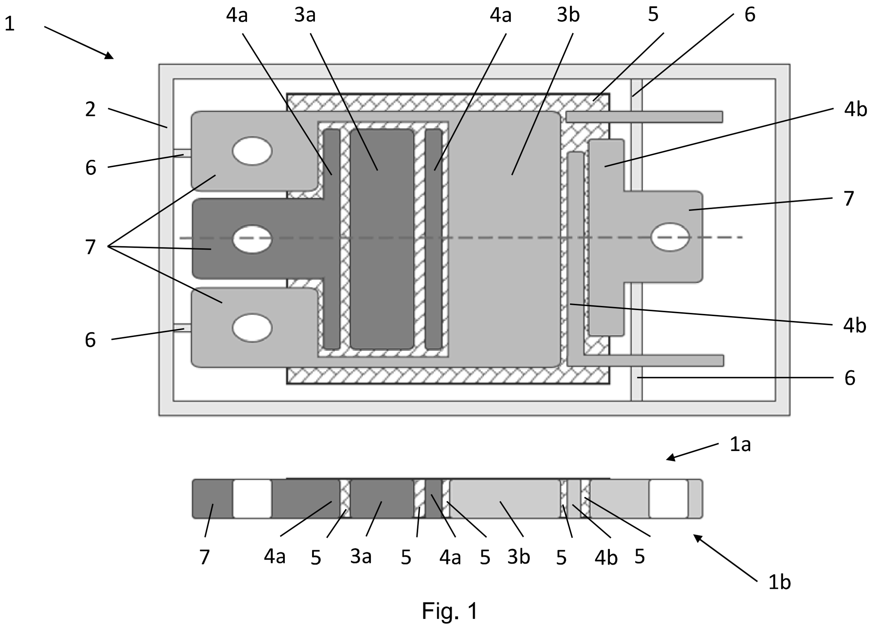

Figure 1 depicts an example of a lead frame structure 1 for use in the method according to the disclosure. The lead frame structure 1 according to the present disclosure, in each example has two surfaces: a first lead frame surface 1a and an opposite second lead frame surface 1b and it comprises an outer frame 2, an at least one lead frame die pad 3a, 3b, an at least one lead frame terminal 4a, 4b and lead frame junctions 6. The lead frame junctions 6 are suitable for interconnections within the lead frame structure 1 and they prevent any displacement during an encapsulation step.

Commonly, the lead frame structure 1 is a structure made of metal, typically copper or its alloys, designed to support the semiconductor die and establish a conductive pathway between the die and external circuits. Typically, the lead frame junctions 6 are part of the lead frame structure 1 and are made of the same material.

The disclosure distinguishes between types of the lead frame die pads 3a, 3b and the lead frame terminals 4a, 4b, identifying the lead frame die pads 3a and the lead frame terminals 4a as floating and the lead frame die pads 3b and the lead frame terminals 4b interconnected by the lead frame junctions 6. In one example, it may occur that both types are present (as it is depicted in Figures 1-3 and 5-7), while in another example, only the floating lead frame die pads 3a and/or the floating lead frame terminals 4a are present.

Figures 1-2 and 5-6 provide clear view of the at least one lead frame die pad 3a and/or the at least one lead frame terminal 4a accommodated in a floating orientation within the lead frame structure. In the solution where a ceramic layer is not applied, the individual lead frame die pads 3a and/or lead frame terminals 4a are not supported by anything.

According to the first aspect of the disclosure, there is provided a method for manufacturing the semiconductor device solving a problem of the floating lead frame die pads 3a and/or lead frame terminals 4a. An example of the method according to the disclosure is shown in Figures 1-3 and 5-6. Such a division of figures refers to two different examples of a pre-binding material.

The method comprises the first step a) of providing the lead frame structure 1 as described above. The lead frame structure 1 is provided with the at least one lead frame die pad 3a, 3b, but in this example is provided with two floating lead frame die pads 3a and two lead frame die pads 3b which are interconnected within the lead frame structure 1. The lead frame structure 1 is provided with the at least one lead frame terminal 4a, 4b, but in this example is provided with two floating lead frame terminals 4a and two lead frame terminals 4b which are interconnected within the lead frame structure 1. In this example, the lead frame terminal 4a, 4b comprises protruding parts being an uncovered lead frame terminal 7. This example comprises two the lead frame terminal 4a, 4b with the uncovered lead frame terminal 7 as it is depicted in Figure 1. The plurality of lead frame junctions 6 are provided for interconnection of certain parts of the lead frame 1.

In a second step b) of the method according to the disclosure the pre-binding material 5 is provided for fixing the floating lead frame die pads 3b and/or floating lead frame terminals 4b within the lead frame structure 1 as it is depicted in Fig. 1-3 or 5, 6.

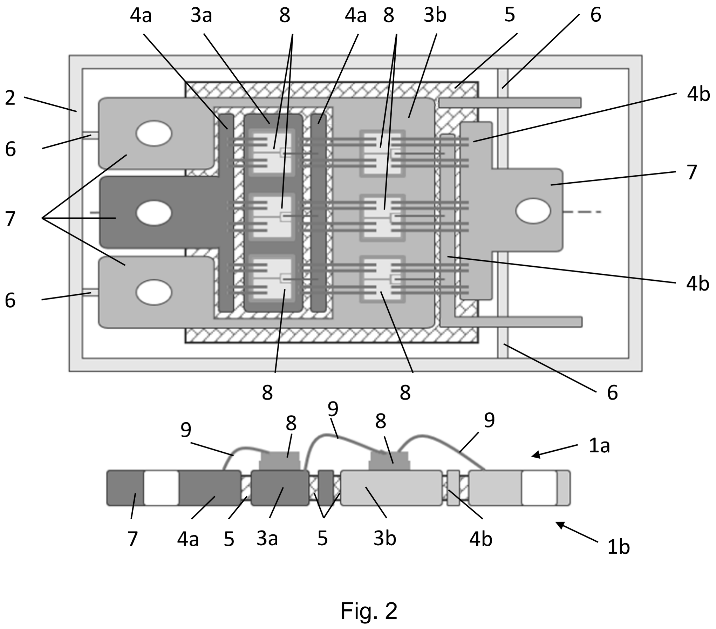

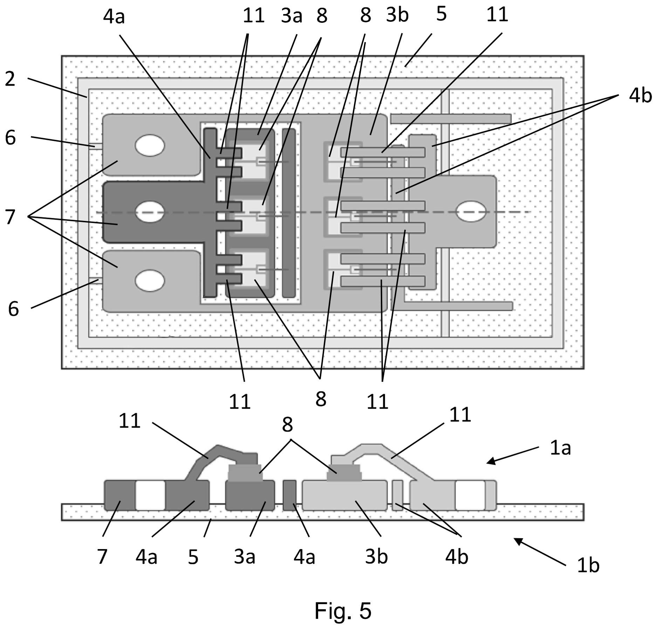

In a third step c) of the method an at least one semiconductor die 8 is mounted on the at least one lead frame die pad 3a, 3b such that semiconductor dies 8 are electrically isolated from one another. The third step is depicted in Figure 2 and 5. The semiconductor die 8 has a first die surface suitable for being attached to the lead frame die pad 3a, 3b and a second die surface suitable for attaching an at least one connecting element 9 for an electrical connection.

The semiconductor dies 8 are mounted onto the lead frame die pads 3a, 3b of the lead frame structure 1 using well-known methods, such as soldering process, eutectic process, epoxy process, UV process, sintering process or diffusion process. The precise alignment of semiconductor dies 8 is significant to ensure process productivity, reliability, quality, efficient electrical signal transmission and effective heat management.

In a fourth step d) of the method the at least one connecting element 9 is mounted for creating the electrical and mechanical connection between the at least one semiconductor die 8 and the at least one lead frame terminal 4a, 4b. The fourth step is depicted in Figure 2 and 5. The connecting elements 9 may be a wire bond, a bond clip or any such mean allowing to conduct current and creating the electrical and mechanical connection between the semiconductor dies 8 and the lead frame terminals 3a, 3b. The wire bonds are thin wires, often made of gold or copper. Such a connection is essential for maintaining the overall performance and signal integrity.

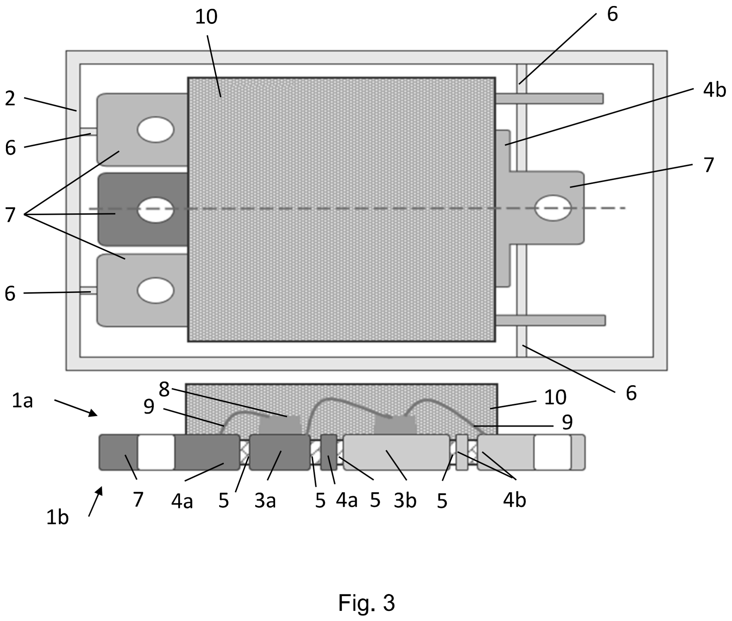

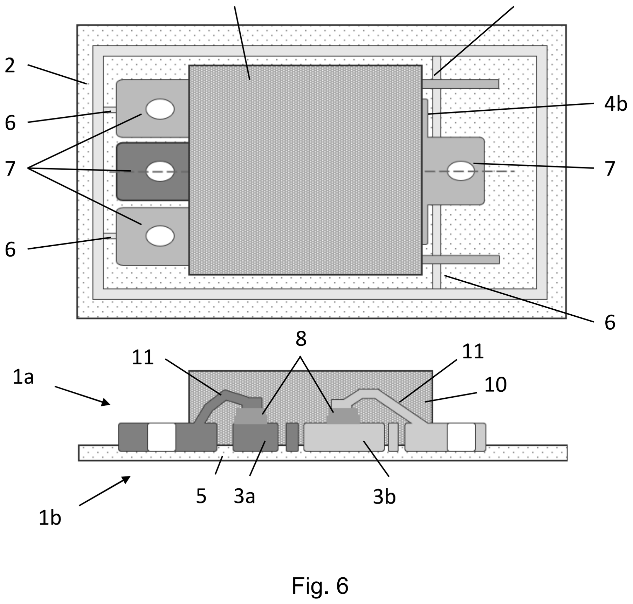

In a fifth step e) of the method occurs an encapsulating step by a mold compound 10. The lead frame structure 1, the at least one semiconductor die 8, the at least one connecting element 9 and the pre-binding material 5 are encapsulated to form the semiconductor device. During an encapsulation step, the at least one lead frame die pad 3a, 3b, the at least one lead frame terminal 4a, 4b and the plurality of lead frame junctions 6 are covered with the mold compound 10. The encapsulation is such that at least part of the at least one lead terminal 4a, 4b being the uncovered lead frame terminal 7 is exposed and extend beyond an edge of the mold compound 10, thereby forming an encapsulated semiconductor power packaging. The mold compound 10 is applied over each semiconductor die 8, the lead frame terminals 4a, 4b, the lead frame die pads 3a, 3b and the other components. It is significant to apply the mold compound 10 over the floating lead frame die pads 3a and/or floating lead frame terminals 4a to hold the floating lead frame die pads 3a and/or floating lead frame terminals 4a in aligned and adjusted positions. The fifth step is depicted in Figure 3 and 6.

A shape of the mold compound 10 is defined by a shape of a moulding form. The encapsulation is essential for protecting the semiconductor die 8 and its connecting elements 9 from an environment - dust, dirt, mechanical damage or moisture. The mold compound 10 may be a plastic encapsulation, a metal encapsulation, a ceramic encapsulation or a metal-ceramic encapsulation. Typically, the mold compound 10 is plastic or epoxy resin.

Figures 1-3 depict an example where the pre-binding material 5 may be an epoxy mold compound EMC, glue or resin. In one example of the disclosure the pre-binding material 5 is a permanent pre-binding material 5 and in another one is a temporary pre-binding material 5.

Figures 1-4 depict placements of the pre-binding material. In this example of the disclosure, the pre-binding material 5 is provided between the at least one lead frame die pad 3a, 3b, the at least one lead frame terminal 4a, 4b and the lead frame junctions 6 as it is depicted in Fig. 1. The pre-binding material 5 is distributed in such a way as to hold the floating parts (lead frame die pads 3a and/or lead frame terminals 4a) in position with the rest of parts of the lead frame structure 1.

In this example, the temporary pre-binding material 5 is suitable for dissolving in a solution in step e1). The fifth step of encapsulation is followed by the removal of the pre-binding material 5 through dissolution. The purpose of the pre-binding material 5 is to hold the lead frame structure 1 with the floating lead frame die pads 3a and/or floating lead frame terminals 4a in position. After the encapsulation process - depicted in Figure 3, the mold compound 10 takes over this role and holds the lead frame structure 1 with its floating components.

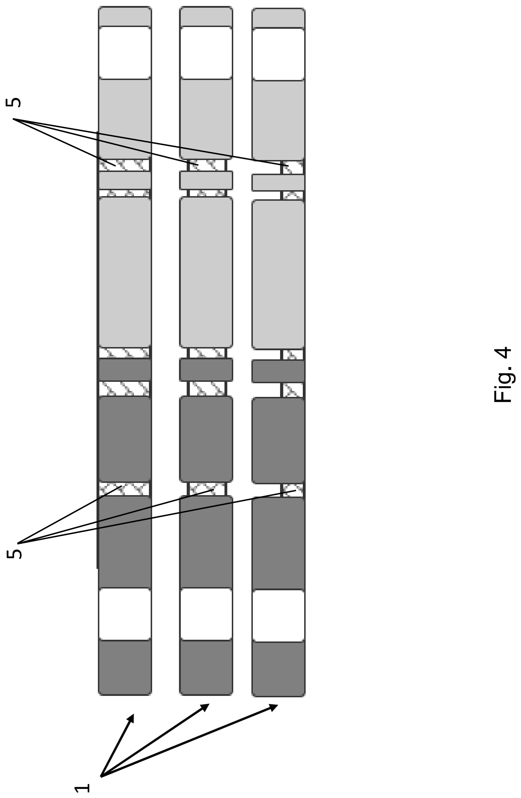

Figure 4 depicts a varying thickness of the pre-binding material 5. To facilitate the dissolving process of the pre-binding material 5, it may be designed with varying thicknesses. Typically, it may have a thickness equal or thinner of a thickness of the lead frame structure 1. In various examples, the pre-binding material 5 may be thinner on the side of the first lead frame surface 1a, the side of the second lead frame surface 1b, or on both the first and second lead frame surface 1a, 1b. Varying thicknesses offer the advantage of reducing material consumption and creating space for the flow of the mold compound.

In the event that the material of the mold compound 10 is compatible with the material of the pre-binding material 5 applied during step e), the pre-binding material 5 is the permanent pre-binding material 5 and is retained as a part of the semiconductor device. If both the mold compound 10 and the pre-binding material 5 are made of EMC, the pre-binding material 5 is preferably retained in the final semiconductor device.

Figures 5-7 depict an example where the pre-binding material 5 is a temporary holding material which is a HT tape or a tray plate with vacuum channels, preferably vacuum channels are adjusted to the lead frame structure 1. Preferably, a size of the pre-binding material in this example should be larger than a size of the lead frame structure 1 to support all the parts of the lead frame structure 1. In this example the pre-binding material 5 is attached to the second lead frame surface 1b in the second step as it is depicted in Figure 5. It secures all the floating lead frame die pads 4a and/or floating lead frame terminals 4a throughout all steps until the encapsulation process is complete. The typical structure of the LF tape in one example comprises a base film and an adhesive layer and may include a non-adhesive layer.

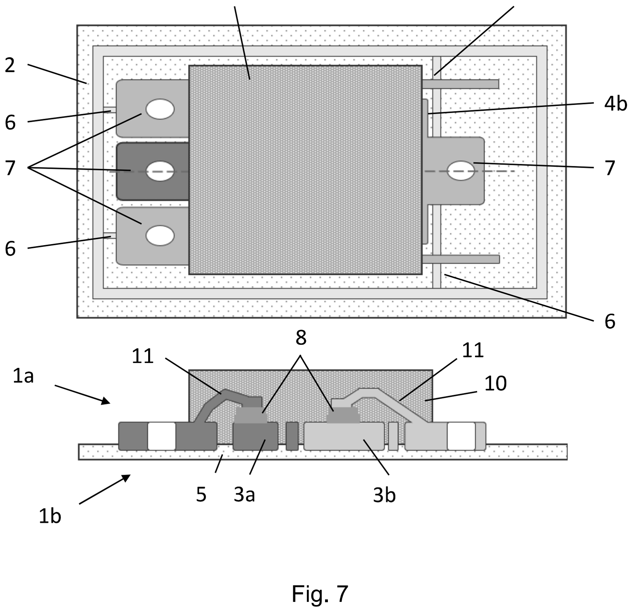

Figures 6 and 7 depict an example where the at least one lead frame die pad 3a, 3b and/or the at least one lead frame terminal 4a, 4b are supported by an at least one clip 11. The clip 11 is used to enhance the fixing force between parts of the lead frame structure 1. Figure 6 depicts an example of the encapsulation where the pre-binding material 5 is the temporary holding material. Figure 7 depicts the example of removal the pre-binding material 5. The fifth step of encapsulation is preferably followed by a step e2) of removal the pre-binding material.

Preferably in one example of the disclosure the lead frame structure 1 is trimmed in a step e3) following the step e) to remove excess components, residual material from the exposed parts of the lead frame structure, such as lead frame junctions 6 and the outer frame 2 which are beyond the mold compound 10, leaving only the uncovered lead frame terminals 7 and/or other possible parts necessary for external connections. In another example, the step e) is followed by step e4) of milling through the encapsulating mold compound 10 and through the plurality of the lead frame junctions 6, thereby interrupting the local interconnection between the at least one lead frame die pad 3b and/or the plurality of lead frame terminals 4b. Milling is preferably conducted by a milling device. Preferably after the step of trimming and/or milling, there is a step of forming the uncovered lead frame terminals 7 for connecting to a printed circuit board, PCB or other electrical components by bending or shaping.

In one example the step e) is followed by step e5) of mounting a heat sink component to the second lead frame surface 1b for transferring generated heat from the lead frame structure 1 to the heat sink.

According to the disclosure, the method described above introduces a semiconductor device characterized by its novelty in manufacturing, achieved through the removal of the ceramic layer and applying the pre-binding material 5. The stabilization previously provided by the ceramic layer is now achieved using the pre-binding material 5 that secures all the parts of the lead frame structure 1 in position throughout the entire manufacturing process. The issue of the floating lead frame die pads 3a and/or floating lead frame terminals 4a is resolved without requiring additional lead frame junctions 6 between the plurality of parts within the lead frame structure 1. Further, the manufactured semiconductor device can be mounted onto the PCB and/or connected to other electrical components.

### LIST OF REFERENCE NUMERALS USED

- 1: lead frame
- 1a: first lead frame surface
- 1b: second lead frame surface
- 2: outer frame
- 3a: floating lead frame die pad
- 3b: lead frame die pad
- 4a: floating lead frame terminal
- 4b: lead frame terminal
- 5: pre-binding material
- 6: lead frame junction
- 7: uncovered lead frame terminal
- 8: semiconductor die
- 9: connecting element
- 10: mold compound
- 11: clip

## Claims

1. A method for manufacturing a semiconductor device, the method comprising:
a) providing a lead frame structure with a first lead frame surface and an opposite second lead frame surface, where the lead frame structure comprises:
an outer frame,
at least one lead frame die pad,
at least one lead frame terminal, and
a plurality of lead frame junctions for local interconnections within the lead frame structure,
wherein the at least one lead frame die pad and/or the at least one lead frame terminal are accommodated in a floating orientation within the lead frame structure,
b) providing a pre-binding material for fixing the floating lead frame die pads and/or floating lead frame terminals within the lead frame structure,
c) mounting at least one semiconductor die on the at least one lead frame die pad,
d) mounting at least one connecting element for creating an electrical connection between the at least one semiconductor die and the at least one lead frame terminal,
e) encapsulating by a mold compound the lead frame structure, the at least one semiconductor die, the at least one connecting element and the pre-binding material, such that at least part of the at least one lead terminal is exposed and thereby forming an encapsulated semiconductor device.

2. The method for manufacturing the semiconductor device according to claim 1, wherein the pre-binding material is an epoxy mold compound EMC, glue or resin.

3. The method for manufacturing the semiconductor device according to claim 2, wherein the pre-binding material is a permanent pre-binding material when the pre-binding material is compatible with the mold compound applied during step e) or a temporary pre-binding material which is suitable for dissolving in a solution.

4. The method for manufacturing a semiconductor device according to claim 2 or 3, wherein in step b) the pre-binding material is provided between the at least one lead frame die pad, the at least one lead frame terminal and the lead frame junctions.

5. The method for manufacturing the semiconductor device according to claim 4, wherein the pre-binding material has a thickness equal or thinner of a thickness of the lead frame structure.

6. The method for manufacturing the semiconductor device according to claim 3, 4 or 5, wherein step e) is followed by a step e1) of dissolving the pre-binding material.

7. The method for manufacturing the semiconductor device according to claim 1 wherein the pre-binding material is a temporary holding material which is a HT tape or a tray plate with vacuum channels, preferably vacuum channels adjusted to the lead frame structure.

8. The method for manufacturing the semiconductor device according to claim 7, wherein in step b) the pre-binding material is attached to the second lead frame surface.

9. The method for manufacturing the semiconductor device according to claim 7 or 8, wherein the at least one lead frame die pad and/or the at least one lead frame terminal are supported by an at least one clip.

10. The method for manufacturing the semiconductor device according to claim 7, 8 or 9 wherein further after step e) is step e2) removing the pre-binding material.

11. The method for manufacturing the semiconductor device according to any one of the preceding claims, wherein step e) is followed by step e3) trimming, using a trimming tool, residual material from the exposed parts of the lead frame structure.

12. The method for manufacturing the semiconductor device according to any one of the preceding claims, wherein step e) is followed by step e4) milling, using a milling device, locally through the mold compound and through the plurality of lead frame junctions, thereby interrupting the local interconnection between the at least one lead frame die pad and the plurality of lead frame terminals.

13. The method for manufacturing the semiconductor device according to any one of the preceding claims, wherein step e) is followed by a step e5) of mounting a heat sink component to the second lead frame surface.

14. A semiconductor device as manufactured in accordance with anyone or more of the method claims 1-13.
